# EUROPEAN PATENT APPLICATION

(11) **EP 3 032 563 A1**
(43) Date of publication of application: **15.06.2016**
(21) Application number: 14197165.5
(22) Date of filing: 10.12.2014
(51) Int. Cl.: H01J 37/256, G01N 23/227

(54) **Analyser instrument**

(71) Applicant: VG Scienta AB, 750 15 Uppsala (SE)
(72) Inventor: Karlsson, Patrik, 752 63 Uppsala (SE); Backlund, Klas, 802 57 Gävle (SE); Åhlund, John, 753 08 Uppsala (SE)
(74) Representative: Zacco Sweden AB

(57) **Abstract**

The present invention relates to an aperture means and an analyser instrument for analysing energies and/or spatial information by means of charged particles emitted from a sample, the particles emitted in result of incident irradiation on the sample. The analyser instrument comprises a lens arrangement for influencing a beam of charged particles emitted from the sample, the arrangement comprising a first aperture means. The lens arrangement is provided with differential pumping means to create differences in pressures at different stages along the optical axis of the lens arrangement. A measurement region is disposed downstream of said lens arrangement and having an inlet opening for receiving said beam of charged particles and the lens arrangement comprises a second aperture means within the differential pumping means. The present invention is characterised in that for a predefined resolution, the second aperture means is configured with respect to its position and size to restrict the angular interval accepted by the analyser instrument in image mode operation so as to maintain the focus point of the analyser instrument also for other modes of operation than the imaging mode.

## Description

### TECHNICAL FIELD

The present invention relates to an analyser instrument, such as a particle spectrometer, for analysing energies and/or spatial information using photoelectron spectroscopy. Moreover, the invention relates to an aperture means and to methods for analysing charged particles emitted from a sample.

### BACKGROUND ART

Charged particle spectrometers, analysers, photoelectron spectrometers, photoemission spectrometers and ion spectrometers are all commonly used designations of analysis instruments for analysing energies and/or spatial information using photoelectron spectroscopy. All of the designations refer to similar instruments, comprising of a lens system, a lens system which is configured to accelerate and retard particles, an energy filter and a detector. The lens system of an analyser can be magnetically and/or electrostatically controlled. The energy filter can be constructed by means of two spheres with positive and negative charges, respectively, to which charged particles are subjected when travelling through the spheres. The flight time of charged particles is another detectable physical property that can be utilised as a parameter to filter out particles having energies within a specific energy interval among particles within a broader energy spectrum. One example of a charged particle analyser is the hemispherical photoelectron spectroscopy type of analyser. Such a hemispherical analyser is described with reference to the published international patent application WO 2013/133739.

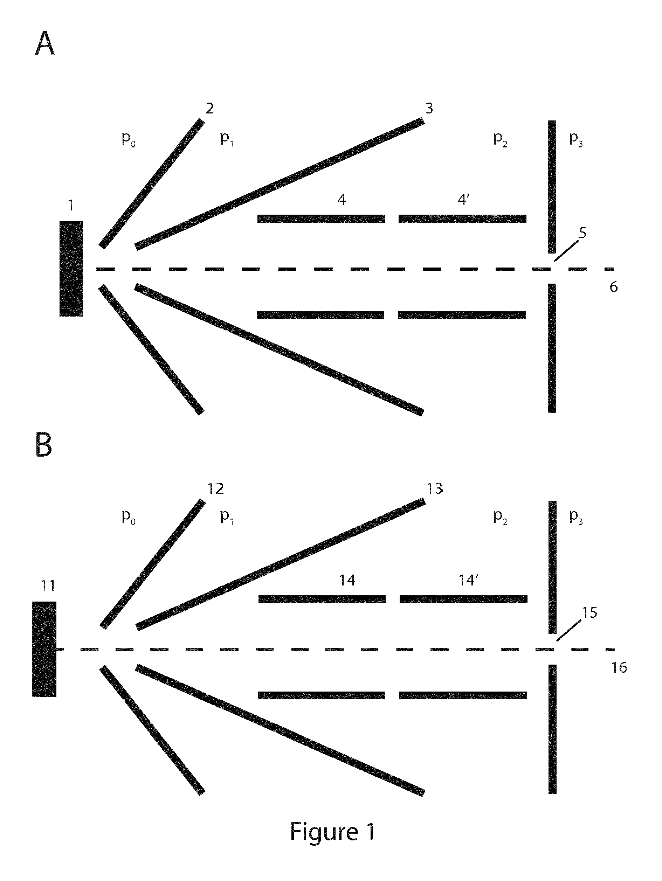

There are numerous ways of achieving spatially resolved charged particle spectra. One way is by illuminating a sample with a small spot x-ray source. The spot width of conventional table top x-ray sources of today are at best the size of a few micrometres or more. Synchrotrons however, could have beam sizes significantly smaller than the mentioned small spot x-ray sources, even down to nanometres. According to the first way of illuminating a sample with an x-ray source, the spatial resolution of the spectrum is determined by the spot size of the x-ray source and the movement of the sample. An alternative way of achieving spatial resolution is by means of a spatially resolved analyser. It is configured to simply restrict the field of view for detection by using one or more apertures or by using an imaging mode lens. During operation of the latter the analyser is adapted to record intensity as a function of distance coordinates and energy, as a result of which spatial resolution can be achieved. Figure 1A schematically illustrates a part of a spatially resolved analyser for image mode operation.

An illuminated sample scatters charged particles in virtually all directions, i.e. charged particles are emitted from the sample with an angular divergence far exceeding the acceptance of the spectrometer. The image mode of operation requires that the charged particles that are analysed by the spectrometer have a very limited angular divergence, typically at most a few degrees. The angular divergence of the charged particles from the sample is therefore normally restricted by means of an entrance aperture positioned in front of the lens. The image mode is then realized by the use of various lens elements arranged along the optical axis of the analyser instrument. In most cases, these lens elements are controlled in such a way that the image of the sample is projected with a magnification downstream along the optical axis, i.e. towards the end of the lens system.

Charged particle analysers usually operate under ultra-high vacuum or high vacuum conditions, which in most arrangements imply that samples are subjected to the same vacuum conditions as the rest of the vacuum vessel, including the analyser and its various lens elements. In order to be able to increase the pressure around the sample, differentially pumped analyser instruments are sometimes used. In experimental arrangements with an increased pressure around the sample, lens elements in the vicinity of the sample with higher pressure are therefore separated from lower pressure sections further downstream the analyser instrument. This is accomplished by means of an entrance aperture means or first aperture means, two designations used equivalently for the same aperture.

The entrance aperture means is typically designed as a truncated cone. That means it is typically provided with a hole at the tip of the cone and has its base opening in a downstream direction, but any functional shape that is capable of separating differently pressurized sections from each other is conceivable. Behind the entrance aperture, a differentially pumped lens system can be arranged with the function to retard or accelerate charged particles. Variations in design, including the differential pumping of individually separated sections in a system, is known from several charged particle spectrometer instruments according to prior art. The differentially pumped system needs to be designed and adapted to operate together with the optical elements of the lens system.

An additional mode of operation, with structural similarities to vacuum-operated analysers, has been described in prior art for high pressure analyser instruments. Those analysers utilise a second aperture, i.e. an additional aperture means located downstream of the entrance aperture, for a subsequent differential pumping section. The function of the second aperture could here be used also as an angular restricting element. The shape of this second aperture could be similar or at least comparable to that of the previously described truncated cone of the entrance aperture. An example of an imaging mode charged particle analyser for high pressures is described with reference to the published article "New ambient pressure photoemission endstation at Advanced Light Source beamline 9.3.2", by Michael E. Grass, Patrik G. Karlsson, Funda Aksoy, Måns Lundqvist, Björn Wannberg, Bongjin S. Mun, Zahid Hussain and Zhi Liu, in Rev. Sci. Instrum. 81, 053106 (2010).

Figure 1 schematically illustrates this arrangement, which enables enhanced electron transmission as well as spectromicroscopy modes with up until 16 µm spatial resolution in one dimension and angle-resolved modes with simulated 0.5 degrees angular resolution at 24 degrees acceptance. Under maximum transmission mode, the electron detection efficiency is significantly improved. However, in order to achieve spatial resolution using the above described arrangement, the focus position of the sample must be altered between two consecutive measurements, meaning that the sample needs to be physically displaced between the already used focus position and a new and different focus position. This new focus position is exclusive for the imaging mode of the analyser.

With reference to the above-described arrangement for spatial mode operation with parallel detection in high pressure photoelectron spectroscopy, the focus is obtained by physically moving the sample further away from the entrance aperture. It clearly seen that the sample is located in a position closer to the entrance aperture in figure 1A than in figure 1B, where the corresponding distance is significantly longer. The entrance aperture is here provided to separate the pressurised section containing the sample from the first pumping section of the analyser. Prior art therefore teaches that the second aperture, which is part of a pressure barrier delimiting a pumping section downstream along the optical axis of the section in which the sample is positioned, could act as an angle restricting aperture for spatial mode measurements.

However, unfortunately an arrangement like this is afflicted with several drawbacks. One of them is that the distance that charged particles have to travel in the elevated pressure regime, denoted p₀ in figure 1, is longer compared to the standard operation of the instrument, compare embodiment B with embodiment A in figure 1. This distance is also longer than a standard distance from the sample to the first entrance aperture, used in high pressure photoelectron spectroscopy. This, in relative terms, longer travelling distance for charged particles increases undesired scattering of electrons in the medium compared to the standard operation of the instrument, when the sample is closer to the entrance aperture. A consequence of this increase in undesired scattering of charged particles is that optical performance of the system is considerably decreased, in particular the transmission.

Thus, there is a need for an analyser instrument for high-pressure applications in which the presently encountered problems of undesired scattering, which leads to decreased transmission and complicated and potentially also inaccurate handling of the optical system are all alleviated, as well as other problems related to prior art technology.

### SUMMARY OF THE INVENTION

It is therefore an object of the invention to provide an analyser instrument for analysing energies and/or spatial information by means of charged particles emitted from a sample, the particles emitted in result of incident irradiation on the sample, the analyser instrument comprising:
a lens arrangement for influencing a beam of charged particles emitted from the sample, the arrangement comprising a first aperture means,
the lens arrangement being provided with differential pumping means to create differences in pressures at different stages along the optical axis of the lens arrangement,
a measurement region disposed downstream of said lens arrangement and having an inlet opening for receiving said beam of charged particles,
the lens arrangement including a second aperture means within the differential pumping means,
   characterised in that
for a predefined resolution, the second aperture means is configured with respect to its position and size to restrict the angular interval accepted by the analyser instrument in image mode operation so as to maintain the focus point of the analyser instrument also for other modes of operation than the imaging mode.

An advantage of a configuration according to the present invention is that one single focus setting can be maintained for different modes of operation. The focus can then be determined by the fixed position of the sample relative to the lens system of the analyser. The focal distance can thus be maintained between consecutive measurements, even if different modes of operation of the analyser instrument are applied. That is highly advantageous both from a performance perspective and a convenience perspective, for a wide variety of scientific applications.

Either or both of the peripheral diameter and the central aperture diameter of the second aperture means are adjustable in one embodiment of the present invention, such that spatial resolution and intensity parameters can be tuned. This allows an operator of the analyser instrument to adjust the focus point for one mode of operation, which focus point is then useful also for other modes of operation of the analyser instrument without the need for readjustments.

A further advantage of the present invention is that the second aperture means is exchangeable both with respect to its position and size. The exchange can be made either by replacing one second aperture means with another, or by adjusting the diameter of its central aperture or the diameter or its periphery. In this way, different spatial resolutions of the analyser instrument can be achieved. A lower resolution will increase the measured intensity whereas a higher resolution will reduce the intensity, which is typically measured as the intensity per resolution point.

In addition to the spatially resolved mode of operation, other conceivable modes of operation for the analyser instrument according to the invention include transmission and/or angular modes of operation. The analyser instrument according to the present invention offers the possibility to be adjusted to the needs of almost any scientific application in the field.

In one exemplary embodiment according to the invention, the second aperture means is integrally arranged with the differential pumping means. This simplifies the practical handling of the analyser instrument and conditions for standard operation can be made more robust. Hereby, the flexibility of the analyser instrument is substantially improved.

According to a preferred embodiment of the invention, the second aperture means is attached to the inside of the first aperture means, typically a truncated cone with an aperture through which the optical axis of the lens system is directed. The second aperture means is preferably attached to the first aperture means in order to be situated on the optical axis in-between the aperture of the first aperture means and the lens arrangement.

As previously described, the present invention allows for adjustments of the peripheral diameter and/or the central aperture diameter of the second aperture means. The second aperture means together with either of the first aperture means and an optional third aperture means could be configured to be exchangeable in-situ and/or ex-situ.

The design of the second aperture means in one embodiment comprises a plurality of apertures or irises, conceivably of different diameters and designs. Also other related configurations are possible, one of which is that the second aperture means is configured to be attached on an optional third aperture means positioned downstream relative to the first aperture means. For such a configuration, there is no need for any additional apertures on the second aperture means except for a central aperture. The embodiment comprising the plurality of apertures or irises has the advantage of allowing pressure gradients between the respective sides of the second aperture means to be equalized, i.e. different pressure sections, a flow that would otherwise have been blocked.

In accordance with a preferred embodiment, the second aperture means is configured substantially in the shape of a disc, the disc comprising:
a central aperture with an enclosing frame, the frame configured to restrict dispersed charged particles from passing through the disc, and
perforated periphery outside of the enclosing frame to allow for pressure equalization between either sides of the disc during differential pumping.

For optimal operation, the disc-shaped configuration of the second aperture means is made of conductive material and/or is provided with a conductive coating.

The present invention also relates to an aperture means, which is particularly adapted to be used in an analyser instrument according to the present invention, the aperture means being configured substantially in the shape of a disc, having:
a central aperture with an enclosing frame, the frame configured to restrict dispersed charged particles from passing through the disc, and
a perforated periphery outside of the enclosing frame to allow for pressure equalization between either sides of the disc during differential pumping.

The analyser instrument can be configured to analyse energies, start directions and/or start positions of charged particles emitted from a particle emitting sample. This applicability to various modes and types of photoelectron spectroscopy measurements increases flexibility and versatility of the analyser instrument.

The analyser instrument according to the present invention provides benefits compared to prior art technologies, as it allows the particle emitting sample to remain fixedly positioned at the standard distance between the sample and the entrance aperture. This obviates the need to move the sample during measurements and also minimises the distance in which the charged particles have to travel in elevated pressures outside the differential pumping means. The minimisation of path length reduces the probability of scattering events for the electrons, and consequently, a higher transmission for spatial imaging mode can be achieved. That is an important performance parameter for this type of instrumentation, which by means of the invention can be significantly enhanced.

The present invention utilises the possibility of using the second aperture means for parallel imaging of the sample also under high pressure environment conditions keeping the same focus. This is not the case for prior art, as this solution has a different focus for the imaging mode, not at the optimum position from a differential pumping and transmission point of view. Furthermore, the second aperture means according to the present invention restricts the acceptance angle for charged particles but does not reduce the pumping capacity of the differentially pumped lens system. Thus, pumping performance of the system is not negatively affected, and the system still offers superior optical measurement properties.

The present invention also allows for easy operation of spatial mode measurements as the sample maintains its fixed and optimum position regardless of which analyser mode is chosen for operation. This is advantageous for an operator in the process of establishing a focus of the analyser instrument. It also decreases current restrictions on sample handling, design of manipulators and chambers, which by means of the invention can be designed for providing optimal properties when taking only a single focus point in consideration instead of a broad range of focus points.

### BRIEF DESCRIPTION OF THE DRAWINGS

Figure 1 is a schematic illustration in a cross-sectional view of a high pressure lens arrangement for spatial resolution according to prior art.
Figure 2 is a schematic illustration in a cross-sectional view of a high pressure lens arrangement including a first aperture means and a second aperture means for spatial resolution according to the present invention.
Figure 3 is a view from the optical axis of a second aperture means according to the present invention. The second aperture means is further configured in the shape of a disc and embodied in various designs.

### DETAILED DESCRIPTION

The present invention relates an analyser instrument, such as a to a particle spectrometer, for analysing energies and/or spatial information using photoelectron spectroscopy. Moreover, the invention relates to an aperture means and to methods for analysing charged particles emitted from a sample. In particular, the analyser instrument according to the present invention is related to ambient pressure photoelectron spectroscopy (APPES).

Figure 1 is a schematic illustration in a cross-sectional view of a high pressure lens arrangement for spatial resolution according to prior art. Figure 1A schematically depicts the geometry for standard operation of the analyser instrument, whereas figure 1B schematically depicts the geometry for spatial mode operation of the analyser instrument.

Figure 1, which for clarity reasons is divided in 1A and 1B, displays elements of a high pressure lens arrangement, such as a sample 1, 11, a cone-shaped aperture means, which hereinafter is called a first aperture means 2, 12. A third aperture means 3, 13 is also displayed, preferably also cone-shaped or otherwise upwardly tapering so as to at least partly reach into the opening of the first aperture means. This design makes the distance along the optical axis 6, 16 between the first and the third aperture means shorter than if the third aperture means would not have been designed to reach into inner regions via the base opening of the first aperture means. This shorter distance is believed to be beneficial, primarily for reasons of improved pumping performance and improved optical accuracy and imaging properties. A more elucidate description of this will follow below. A schematic set of lens elements 4, 4', 14, 14', are further displayed as cross-sections of cylinders. It is obvious to the skilled person that any number of lens elements, in a variety of different designs and experimental set-ups, could be used. The chosen configuration of the lens elements depend on the intended application and operational mode of the analyser instrument. Also other conditions that influence results of measurements may be taken into account when deciding on the optimum number of lens elements, design and arrangement.

A differential voltage can be applied over the lens elements 4, 4' and 14, 14' respectively, so as to activate the lens operation which is shaping a beam of the charged particles emitted from the sample and travelling substantially along the optical axis. An exit aperture 5, 15, typically a slit, is provided downstream of the lens elements, also along the optical axis of the lens system. Behind the exit aperture is located the measurement region including all or at least one of the following components: lens elements, energy filter and detector means.

Differentially pumped pressure sections, to which different pressures can be achieved during operation of the analyser instrument are displayed as p₀, p₁, p₂,..., pₙ.

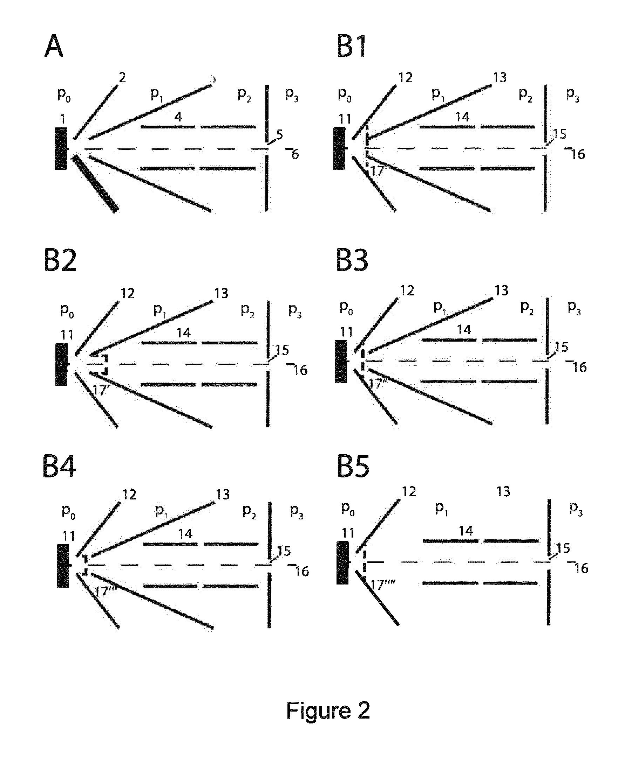

Figure 2 is a schematic illustration in a cross-sectional view of a high pressure lens arrangement for spatial resolution according to the present invention. Figure 2A schematically depicts the geometry for standard operation of the analyser instrument, whereas figure 2B1-2B5 schematically depicts the geometry of different preferred embodiments for spatial mode operation of the analyser instrument.

Figure 2, divided in 2A and 2B1-2B5, displays elements of a high pressure lens arrangement, such as the sample 1, 11, a cone-shaped aperture means, which hereinafter is called a first aperture means 2, 12. A third aperture means 3, 13 is also displayed, preferably also cone-shaped or otherwise upwardly tapering so as to reach inside the opening of the first aperture means. The third aperture means is optional, which is illustrated in the embodiment of figure 2B5, in which the third aperture means has simply been removed. Lens elements 4, 14 are further displayed as cross-sections of cylinders.

A beam of the charged particles emitted from the sample is travelling substantially along the optical axis 6, 16. An exit aperture 5, 15, typically a slit, is provided downstream of the lens elements, also along the optical axis of the lens system.

Differentially pumped pressure sections, to which different pressures can be applied during operation of the analyser instrument are displayed as p₀, p₁, p₂, ..., pₙ.

The difference of the embodiment of figure 2B1-2B5 as compared to figure 1B is the presence of a second aperture means 17, 17', 17", 17"', 17"". The function of this second aperture means has been previously described in detail, and the design of it differs between embodiments. Four of the displayed embodiments, 2B1, 2B3, 2B4 and 2B5, show that the second aperture means can be attached to the inside of the truncated cone-shape of the first aperture means, although at different distances from the entrance aperture of the first aperture means. The embodiment of 2B2 shows that the second aperture means could also be attached to the optional third aperture means.

With further reference to figure 2, this position of the sample is typically fixed for all modes of operation of the analyser instrument and lens tables can be developed to determine conceivable and optimal working distances between the lens and the sample. The sample is located in the high pressure region of the analyser instrument in front of the first aperture means. The first differential pumping stage is located behind the first aperture means. Provided that a second pumping stage is required, so as to reach sufficient pumping performance, that second pumping stage is located behind the previous pumping stage. In this embodiment, the second pumping stage is separated from the first pumping stage by a truncated cone. The location of the second aperture means is in figure 2B1 located at the entrance of the optional third aperture means. Behind the third aperture means, a set of lens elements is indicated. These elements are used to achieve the spatial resolution measured by the detector for the imaging mode and for achieving for instance angular resolution in angular mode.

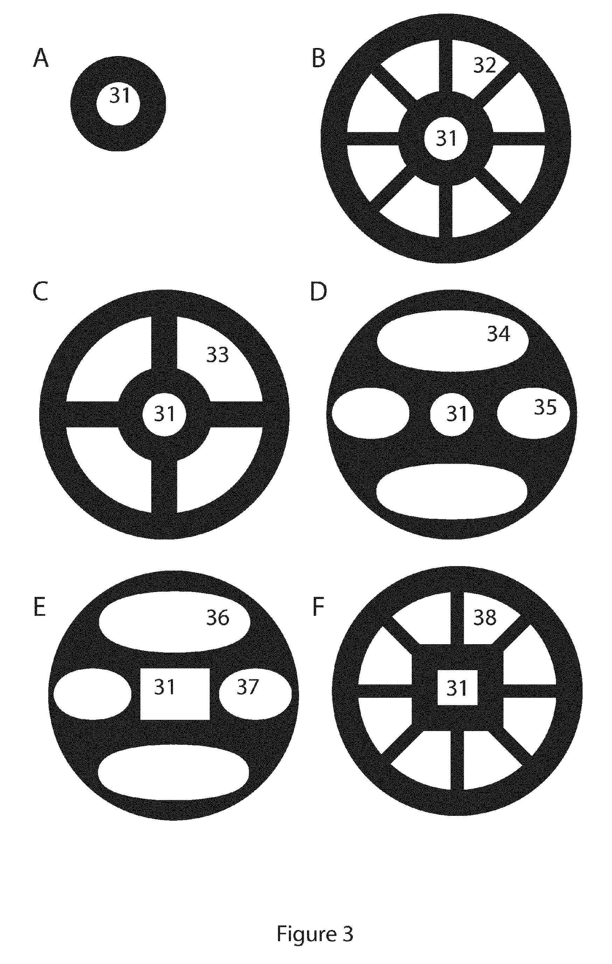

Figure 3 is a view from the optical axis of a second aperture means when formed as a disc. It is designed differently in the different embodiments A-F, although with similar functionality. All of the designs displayed comprise a centre aperture 31 to allow charged particles to pass through the disc. This centre aperture is surrounded by a barrier for travelling charged particles. A number of differently shaped aperture designs 32-38 for equalizing pressure are placed in the area, which is on the outside delimited by the periphery and on the inside by the barrier of the second aperture means.

The size of the first aperture means of the analyser instrument is variable and a compromise between maximising throughput of particles emitted from the sample (larger radius) at low pressure and increasing the maximum pressure of the system (smaller radius).

The application of photoelectron spectroscopy to science of various disciplines has long driven the advancement of analyser instruments to function at higher pressures. While such systems have been developed for many years, ambient pressure photoelectron spectroscopy (APPES) has gained popularity in the past decade due to advances in the construction of electron analysers. For completeness, APPES is also known as near ambient photoelectron spectroscopy (NAP PES) and high pressure photoelectron spectroscopy (HIPP, HPPES). Also the exploitation and development of synchrotron facilities with high brightness, tuneable, monochromatic light with small spot size has been instrumental in gaining popularity of the analysis method, also in many related inter-disciplinary fields of research.

There are numerous design criteria for a system according to the present invention, in addition to those for analyser instruments under ultra-high vacuum conditions. A first design criterion is that the ultra-high vacuum environment of the x-ray source should be separated from the elevated pressure of the analysis chamber. This is typically accomplished by the use of an x-ray transparent window, e.g. a thin silicon nitride or aluminium coated window.

According to a second design criterion, the analysis chamber needs to be separated from the electrostatic elements and electron detector, which operates in high vacuum. This is accomplished by the provision of means for differential pumping through a series of apertures. The radius of the aperture between the analysis chamber and the first pumping section, in large part defines the ultimate pressure limit of the system. The radius, typically in the range of 0.1-1 mm, determines the gas conductance from the analysis chamber into the analyser lens column. It also sets the minimum distance between the sample and aperture and therefore the photoelectron transmission through the gas. This minimum distance is one of the factors that determine the upper limit of workable pressure, whereas the other is the effectiveness of the combined lens and differential pumping arrangement. The above-mentioned design criteria for efficient operation of an analyser instrument are all achievable using a second aperture means according to the present invention.

An open first aperture means, preferably shaped as a truncated cone, also allows for the possibility to put a third aperture, conceivably also in the shape of a truncated conical lens element, very close to the first aperture means. Several benefits are achieved with this construction, such as increased efficiency of the differential pumping, as a large portion of the gas load is channelled towards the first pumping stage. The construction further allows for provision of electron optics early in the path, making it possible to keep the charged particle trajectories close to the optical axis. This in turn allows for a design without a node causing aberrations, as a result of which enhanced point-to-point imaging can be achieved, limited to relatively small angular intervals. For situations a two-dimensional detector and high pass energies are used, it is further an advantage to consider the position of the node, which is a function of kinetic energy, such that the chromatic effect of the recorded spectra can be minimised.

The second differential pumping stage may comprise additional lens elements and typically ends with an exit slit. The size of this slit is matched to the larger size analyser entrance slit of for instance a hemispherical type of analyser instrument, provided such a hemisphere is used as an energy filter. The position of the exit slit is in the standard sample position of the lens. Using a matched exit slit gives sufficient differential pumping properties at this stage without reducing the electron throughput. Most importantly, the use of an exit slit provides the dynamical freedom necessary to operate complex lens modes stably and continuously over large energy ranges.

In accordance with the invention, charged particles, such as electrons, are shaped by a lens system in a beam of particles, concentric around a centre axis of the beam. A measurement region is disposed downstream of said lens arrangement and is provided with an inlet opening, preferably a slit opening as previously described, for receiving said electron beam. The aperture sizes in the optical system of multiple lenses can be altered such that spatial resolution and intensity parameters can be optimized. The second aperture means is removable and can be exchanged by releasing the first aperture means, which is shaped as a truncated cone or cylinder, from the differentially pumped lens arrangement. It can also be exchanged in-situ or by first removing the first or third aperture means using for example a liner transfer or wobble stick solution holding a set of apertures.

The centre hole of the second aperture means is configured so as to restrict the angular acceptance further downstream the lens, which significantly and as previously described improves the spatial resolution of the instrument. It is possible to change the centre aperture diameter with a resulting increase in intensity, but at the cost of spatial resolution. The design of the second aperture means may therefore be constituted in a way that several different centre aperture diameters of the second aperture means can be realized.

## Claims

1. An analyser instrument for analysing energies and/or spatial information by means of charged particles emitted from a sample (1, 11), the particles emitted in result of incident irradiation on the sample, the analyser instrument comprising:
a lens arrangement (4, 14) for influencing a beam of charged particles emitted from the sample, the arrangement comprising a first aperture means (2, 12),
the lens arrangement being provided with differential pumping means to create differences in pressures (p₀, p₁, p₂, ..., pₙ) at different stages along the optical axis (6, 16) of the lens arrangement,
a measurement region disposed downstream of said lens arrangement and having an inlet opening (5, 15) for receiving said beam of charged particles,
the lens arrangement comprises a second aperture means (17, 17', 17", 17"', 17"") within the differential pumping means,
**characterised in that**
for a predefined resolution, the second aperture means is configured with respect to its position and size to restrict the angular interval accepted by the analyser instrument in image mode operation so as to maintain the focus point of the analyser instrument also for other modes of operation than the imaging mode.

2. An analyser instrument according to claim 1, wherein the other modes of operation includes a spatially resolved mode of operation.

3. An analyser instrument according to claim 1, wherein the other modes of operation includes transmission and/or angular modes of operation.

4. An analyser instrument according to claim 1, wherein the second aperture means is integrally arranged with the differential pumping means.

5. An analyser instrument according to claim 1, wherein the second aperture means is attached to the inside of the first aperture means, and located on the optical axis in-between the aperture of the first aperture means and the lens arrangement.

6. An analyser instrument according to anyone of claims 1-5, wherein the peripheral diameter and/or the central aperture diameter of the second aperture means are adjustable.

7. An analyser instrument according to anyone of claims 1-6, wherein the second aperture means is configured to be exchangeable either in-situ and/or ex-situ.

8. An analyser instrument according to anyone of claims 1-7, wherein the second aperture means comprises a plurality of apertures or irises (31-38), preferably of different diameters and shapes.

9. An analyser instrument according to anyone of claims 1-7, wherein the second aperture means is configured to be attached on a third aperture means positioned downstream relative to the first aperture means.

10. An analyser instrument according to anyone of claims 1-9, wherein the second aperture means is configured substantially in the shape of a disc, the disc comprising:
a central aperture with an enclosing frame, the frame configured to restrict dispersed charged particles from passing through the disc, and
a perforated periphery outside of the enclosing frame to allow for pressure equalization between either sides of the disc during differential pumping.

11. An analyser instrument according to claims 10, wherein the disc of the second aperture means is made of conductive material and/or is provided with a conductive coating.

12. An analyser instrument according to anyone of claims 1-11, wherein the instrument is of the photoelectron spectroscopy type of analyser.

13. Aperture means adapted to be used in an analyser instrument according to anyone of claims 1-12, the aperture means being configured substantially in the shape of a disc, the disc comprising:
a central aperture with an enclosing frame, the frame configured to restrict dispersed charged particles from passing through the disc, and
perforated periphery outside of the enclosing frame to allow for pressure equalization between either sides of the disc during differential pumping.
